# EUROPÄISCHE PATENTSCHRIFT

(11) **EP 1 072 658 B1**
(45) Veröffentlichungstag und Bekanntmachung des Hinweises auf die Patenterteilung: **13.10.2004**
(21) Anmeldenummer: 00115490.5
(22) Anmeldetag: 18.07.2000
(51) Int. Cl.: C09D 133/00, C08G 59/50

(54) **Verfahren zur Haftungsverbesserung von Acrylatharzen**
Process for improving the adhesiveness of acrylate resins
Procédé pour l'amélioration d'adhésion de résines d'acrylate

(30) Priorität: 19.07.1999 DE 19933741
(43) Veröffentlichungstag der Anmeldung: 31.01.2001
(73) Patentinhaber: BASF AKTIENGESELLSCHAFT, 67056 Ludwigshafen (DE)
(72) Erfinder: Reich, Wolfgang, 67133 Maxdorf (DE); Enenkel, Peter, 67258 Hessheim (DE); Keil, Edmund, 67259 Heuchelheim (DE); Lokai, Matthias, 67677 Enkenbach-Alsenborn (DE); Beck, Erich, 68526 Ladenburg (DE); Menzel, Klaus, 97069 Ludwigshafen (DE)
(74) Vertreter: Kinzebach, Werner, Dr.

(56) Entgegenhaltungen:
- US-A- 4 032 482
- US-A- 4 051 195
- US-A- 4 336 116
- US-A- 5 516 860
- US-A- 5 756 829
- PATENT ABSTRACTS OF JAPAN vol. 1999, no. 08, 30. Juni 1999 (1999-06-30) & JP 11 080322 A (MITSUBISHI GAS CHEM CO INC), 26. März 1999 (1999-03-26)

## Beschreibung

Die Erfindung betrifft ein Verfahren zur Verbesserung der Haftung von strahlungshärtbaren Acrylatharzen, die Amingruppen enthaltende Acrylate enthalten, auf Substraten durch Zumischen und Aminhärten einer Polyepoxidverbindung.

Strahlungshärtbare Lacke auf der Basis von Acrylatharzen sind bekannt und werden oft für Beschichtungen von Substraten wie Metallen oder Kunststoffformkörpern verwendet. Durch den bei der Strahlungshärtung auftretenden Polymerisationsschwund der auf das Substrat aufgetragenen Lackschicht wird die Haftung des Lackes auf dem Substrat negativ beeinflußt. Es ist bekannt, die Haftung der strahlungshärtbaren Lackschicht durch eine Erhöhung des Molekulargewichts der Lackharze, eine Verringerung ihrer Doppelbindungsdichte oder durch Zusatz von nicht-reaktiven Polymeren zu verbessern. Dies führt jedoch zu einem unerwünschten starken Anstieg der Viskosität der Lacke. Es besteht ohne Zweifel ein Bedarf an strahlungshärtbaren Lacken auf Basis von Acrylatharzen, die eine gute Haftung auf Metall- oder Kunststoffsubstraten haben.

Es wurde nun gefunden, daß die Haftung von strahlungshärtbaren Lacken auf der Basis von Acrylatharzen als Bindemittel zu Substraten verbessert werden kann, wenn die Lacke mindestens eine Verbindung mit Amin- und ungesättigten Acrylatgruppen sowie in kleiner Menge Polyepoxidverbindungen enthalten und man die auf das Substrat aufgetragene Lackschicht mit energiereicher Strahlung härtet und bei einer Temperatur von über 50 °C, insbesondere von ca. 50 bis 120 °C lagert bzw. tempert.

Gegenstand der vorliegenden Erfindung ist somit ein Verfahren zur Verbesserung der Haftfestigkeit von strahlungshärtbaren Acrylatharzen oder deren Mischungen, die eine Verbindung mit mindestens einer Amin- und mindestens einer strahlungshärtbaren ungesättigten Acrylatgruppe enthalten, auf Substraten, das dadurch gekennzeichnet ist, daß man den Acrylatharzen mindestens eine Polyepoxidverbindung mit einem Epoxidwert von 1 bis 15 mol/kg zumischt, die auf das Substrat aufgetragene Schicht aus dem erhaltenen Acrylatharz mit energiereicher Strahlung härtet und durch Behandlung bei einer Temperatur von über 50 °C eine zumindest teilweise Aminhärtung der Polyepoxidverbindungen durchführt.

Das durch Zumischen der Polyepoxidverbindung(en) erhaltene Acrylatharzgemisch wird im folgenden auch als Lack oder Lackgemisch bezeichnet.

Es war überraschend, daß das Verfahren nicht nur zu verbesserten Haftfestigkeiten zwischen dem Substrat wie einem Metallblech oder einer Kunststofffolie und der gehärteten Lackschicht führte, sondern auch eine Verminderung der Rißbildung in den Lackschichten und eine Herabsetzung der Vergilbung der Lacke bewirkte. Überraschend war auch die gute Lagerstabilität der ungehärteten Mischungen im Vergleich zu Mischungen, die Epoxidharze und niedermolekulare aliphatische Amine als Härter enthalten.

Unter Acrylatharzen werden bekannte harzförmige Umsetzungsprodukte verstanden von (i) Methacrylsäure und/oder Acrylsäure mit (ii) mindestens zwei Hydroxylgruppen enthaltenden Polyestern, Polyethern, Polyurethanen oder Epoxyharzen (die mindestens zwei mit (Meth)acrylsäure reagierende funktionelle Gruppen enthalten), sowie Umsetzungsprodukte von (i) Hydroxyalkyl(meth)acrylaten mit (ii) Isocyanatgruppen enthaltenden Verbindungen. Solche strahlungshärtbare Acrylatharze sind handelsüblich und z.B. in P.K.T. Oldring, Chemistry & Technology of UV & EB Formulation for Coatings, Inks & Paints, Vol.II: Prepolymers & Reactive Diluents, J.Wiley and Sons, New York und Sita Technology Ltd., London 1997, oder in H.Kittel, Lehrbuch der Lacke und Beschichtungen, Band VII: Verarbeitung von Lacken und Beschichtungsmaterialien, S.240-245 etc., Verlag W.A.Colomb, Berlin 1979 beschrieben. Die Acrylatharze, die je nach Herstellung und wiederkehrenden Struktureinheiten in der Molekülkette in Polyesteracrylate, Polyetheracrylate, Urethanacrylate, Epoxyacrylate und Melaminacrylate unterteilt werden, sind als sogenannte strahlungshärtbare Präpolymere relativ niedermolekular und haben im allgemeinen ein durchschnittliches Molekulargewicht Mₙ von 300 bis 15000 und bevorzugt von 400 bis 3000 g/mol, bestimmt duch Gelpermeationschromatographie (GPC) mit Polystyrol als Standard und Tetrahydrofuran als Elutionsmittel. Die Harze enthalten im allgemeinen 0,1 bis 1,0 und bevorzugt 0,1 bis 0,5 mol an polymerisierbaren C-C-Doppelbindungen pro 100 g Präpolymer. Sehr geeignete (Meth)acrylatharze enthalten 2 bis 20, insbesondere 2 bis 10 und bevorzugt 2 bis 6 Methacryloyl- und/oder Acryloylgruppen im Molekül. Von den Acrylatharzen sind solche besonders geeignet, die sich von mehrfunktionellen aliphatischen Alkoholen ableiten, die neben den Hydroxylgruppen keine weiteren funktionellen Gruppen aufweisen, abgesehen von Ether-, Ester- und Urethangruppen. Beispiele von Alkoholen sind z.B. di-,tri- und höherwertige Alkohole wie Propylenglykol, Diethylenglykol, Triethylenglykol, Butandiol, Hexandiol, Neopentylglykol, Cyclohexandiol, Glyzerin, Trimethylolpropan, Di-trimethylolpropan, Pentaerythrit, Di-pentaerythrit oder Sorbit. Zur Herstellung von Polyesteracrylaten kommen vorwiegend aliphatische Polyesterpolyole in Betracht. Polyesteracrylate können ein- oder mehrstufig aus Polyolen, Polycarbonsäuren und (Meth)acrylsäure hergestellt werden. Sie sind z.B. in der EP-A 279303 beschrieben. Zur Herstellung von Polyetheracrylaten eignen sich besonders alkoxylierte, bevorzugt ethoxylierte und/oder propoxylierte mehrwertige Alkohole, worin der Alkoxylierungsgrad je Hydroxylgruppe 0 bis 10 betragen kann.

Gemäß dem erfindungsgemässen Verfahren enthalten die Acrylatharze im Gemisch Verbindungen mit mindestens einer Amingruppe und mindestens einer strahlungshärtbaren ungesättigten Acrylatgruppe, insbesondere aminmodifizierte Acrylatharze mit einem Molekulargewicht Mₙ von mindestens 300 und bevorzugt mindestens 400 g/mol. Die Mischungen können Gemische von amingruppenfreien Acrylatharzen mit Verbindungen mit mindestens einer Amingruppe und mindestens einer strahlungshärtbaren ungesättigten Acrylatgruppe wie einem aminmodifizierten Acrylatharz darstellen, man kann aber mit Vorteil auch ausschließlich aminmodifizierte Acrylatharze als Bindemittel verwenden. Unter aminmodifizierten Acrylatharzen werden hier Acrylatharze verstanden, die Michael-Addukte von aliphatischen Aminen mit primären und/oder sekundären Aminogruppen enthalten. Diese können aminmodifizierte Polyether-, Polyester-, Epoxy- und Urethanacrylate sein, wobei Polyether- und Polyesteracrylate bevorzugt sind. Sehr geeignet sind Acrylatharze, in denen 0,5 bis 60 und insbesondere 0,5 bis 30 mol% der (Meth)acryl-Gruppen als Michael-Addukte eines Amins mit einer primären und/oder sekundären Aminogruppe vorliegen. Die Herstellung von aminmodifizierten Acrylatharzen ist z.B. in den Patentanmeldungen DE-A 2346 424, DE-A 4007 146, EP-A 211 978, EP-A 280 222 oder EP-A 731 121 beschrieben. Für das erfindungsgemäße Verfahren sind aminmodifizierte Acrylatharze besonders geeignet, die eine Aminzahl von 5 bis 450 und bevorzugt 20 bis 250 mg KOH/g aufweisen. Die Mischung der Lackkomponenten soll eine Aminzahl von 5 bis 250, insbesondere 5 bis 100 und bevorzugt 20 bis 50 mg KOH/g enthalten. Auch Aminsynergisten auf Basis von multifunktionellen Monomeren können in manchen Fällen mitverwendet werden.

Die erfindungsgemäßen Lackmischungen enthalten neben der Verbindung mit Amingruppen mindestens eine mit einem Amin härtbare Polyepoxidverbindung mit einem Epoxidwert von 1 - 15 und insbesondere 3 - 8 mol/kg. Bevorzugt sind aliphatische Polyepoxide sowie aliphatische oder aromatische Glycidylether und Glycidylester mit mindestens 2 Glycidylgruppen. Sehr geeignete Polyepoxide sind aliphatische Glycidylether wie Pentaerythrittriglycidylether, Trimethylolpropan-triglycidylether, Glycerintriglycidylether und Neopentylglykoldiglycidylether. Die Epoxidgruppen der Polyepoxidverbindungen können auch partiell mit (Meth)acrylsäure umgesetzt sein, sofern zwei intakte Epoxidgruppen im Molekül verbleiben. Die Molekulargewichte geeigneter Polyepoxidverbindungen liegen im allgemeinen unter 2000 und bevorzugt unter 1100 g/mol. Die Menge der Epoxidverbindungen in der Mischung richtet sich nach deren Epoxidwert und der Menge der anderen Bestandteile der Mischung, wobei die Acrylatharzmischung einen Epoxidwert von 0,1 bis 4, insbesondere 0,1 bis 2 und bevorzugt von 0,1 bis 1 mol/kg aufweisen soll.

Die erfindungsgemäß verwendeten Acrylatharzmischungen können ferner, insbesonders zur Einstellung der Viskosität oder Beeinflussung der Härte der Lackschichten, auch sogenannte Reaktivverdünner enthalten, d.h. strahlungshärtbare Monomere mit insbesondere 1-4 C-C-Doppelbindungen. Geeignete Monomere und deren Auswahlkriterien sind z.B. beschrieben in dem vorstehend im Zusammenhang mit den strahlungshärtbaren Acrylatharzen zitierten Buch von P.K.T.Oldring, Vol.II, Chapter III, S.261-325. Den Acrylatharz-Mischungen können ferner auch übliche Zusätze zugesetzt werden wie Mattierungsmittel, Füllstoffe, Pigmente, Verlaufshilfsmittel etc. Die Menge dieser üblichen Zusätze liegt im allgemeinen bei 0,01 bis 20 und bevorzugt bei 0,05 bis ca. 10 Gew.% der Gesamtmenge der Mischung.

Die Acrylatharzmischungen lassen sich in bekannter Weise auf Substrate wie Metalle oder Kunststoffe, beispielsweise Polyethylen, Polypropylen, Polyurethane etc., auftragen wie durch Rakeln, Spritzen, Gießen oder Walzen.

Die Strahlungshärtung der Lackschichten kann mit Hilfe von energiereicher Strahlung, wie UV-Strahlen, Elektronen- oder Gammastrahlen erfolgen. Bevorzugt wird mit UV-Licht gehärtet. Dabei ist es erforderlich, den Mischungen mindestens einen Photoinitiator in einer Menge von 0,05 bis 20 und bevorzugt von 0,05 bis 5 Gew.%, bezogen auf die Gesamtmenge der Acrylatharzmischung, zuzumischen. Hierzu sei auf die umfangreiche Literatur verwiesen, z.B. auf P.K.T. Oldring, Chemistry & Technology of UV & EB Formulation for Coatings, Inks & Paints, SITA Technology, London 1991, Vol.III: Photoinitiators for Free Radical and Cationic Polymerisation. Als Beispiele von Photoinitiatoren seien genannt Benzophenon, Alkylbenzophenone, halogenierte Benzophenone, Michlers Keton, Anthron, Anthrachinon und seine Derivate, Benzoin und seine Derivate sowie Acylphosphinoxide wie 2,4,6-Trimethylbenzoyldiphenylphosphinoxid. Die Reaktivität bei der UV-Polymerisation kann in üblicher Art durch Zusatz von tert. Aminen wie Triethylamin, Triethanolamin oder Aminsynergisten (z.B. Laromer® LR 8956) gesteigert werden. Zur Durchführung der Strahlungshärtung mit UV-Licht eignen sich künstliche Strahler, deren Emission im Bereich von 2500 - 5000, vorzugsweise 2500 - 4000 Angström liegt. Als Strahler sind Quecksilberdampf-, Xenon- und Wolframlampen geeignet, wobei die Verwendung von Quecksilberhochdruckstrahlern bevorzugt ist. Hierbei ergibt die Strahlungshärtung eine kratzfeste Lackschicht.

Zur thermischen Härtung oder teilweisen Härtung des Polyepoxid-Amin-Systems wird die bestrahlte Lackschicht bei Temperaturen von über 50 °C, insbesondere von 50 bis 120 °C und vorzugsweise von 60 bis 120 °C behandelt (getempert). Temperatur und Zeitdauer des Temperns werden von dem speziell verwendeten Epoxid/Amin-System mitbestimmt und können auf einfache Weise in Vorversuchen optimiert werden. Im allgemeinen wird während ca. 5 bis 240 Minuten getempert, oft auch länger. Es wurde festgestellt, daß die durch das Tempern eingeleitete Härtungsreaktion oft längere Zeit weitergeht, selbst wenn man die Beschichtung inzwischen auf Raumtemperatur hat abkühlen lassen, was zu einer weitergehenden Verbesserung der Haftfestigkeit führt.

Die resultierenden Acrylatharzschichten haben die oben angegebenen überraschenden vorteilhaften Eigenschaften. Sie sind daher besonders geeignet zur Herstellung von Metall- und Kunstoffbeschichtungen.

Die nachstehenden Beispiele und Vergleichsversuche sollen die Erfindung weiter erläutern, aber nicht beschränken.

Soweit nicht anders angegeben, beziehen sich Teile und Prozente auf das Gewicht.

Die Bestimmung des Epoxidwertes bzw. des Epoxid-Äquivalentgewichts erfolgte nach DIN 53188 durch Titration einer in einem Dichlormethan-Essigsäure-Gemisch gelösten Harzlösung, der Tetra-n-butylammoniumjodid und Kristallviolett als Indikator zugesetzt waren, mit 0,1 n-Perchlorsäure bis zum blau-gelbgrünen Farbumschlag. Der Epoxidwert gibt an, wieviel Mol Epoxidgruppen in 100 g eines Epoxidharzes enthalten sind. Es besteht die Relation Epoxidwert = 100 / Epoxid-Äquivalentgewicht.

Die Aminzahl gibt an, wieviel mg KOH 1 g der Substanz äquivalent sind. Sie wird bestimmt durch Lösen von 1-2 g der Epoxidharzprobe in 50 ml Essigsäure, Zugabe von Kristallviolettlösung als Indikator und Titration mit 0,1 n-Perchlorsäure in Essigsäure bis zum Farbumschlag des Indikators von blau nach gelbgrün.

Als Maß der Flexibilität wurde vor und während des Temperns die Erichsentiefung (ET) nach DIN 56 156 in mm ermittelt, wobei hohe Werte eine hohe Flexibilität bedeuten.

Zur Prüfung der Haftung wurde der Gitterschnittwert (GT) nach ISO 2409 (DIN 53151) jeweils ohne und mit Tesafilmabriß (mT) vor und während des Temperns ermittelt.

In Tabelle 3 wurde bei einem Lackauftrag von 25 g/m² auf ein Tiefziehblech ferner die Haftfestigkeit in N/mm² mit dem Torsionsmeßgerät Twistometer bestimmt. Die Methode ist in Farbe und Lack 80.Jhrg. 10/1974 sowie in dem BASF-Merkblatt "Bestimmung der Haftfestigkeit" PM/ED 038d (Jan.1999) beschrieben. Das Twistometer erhöht durch kontinuierliches Drehen einer Welle das Drehmoment auf zuvor hergestellte Klebezapfen bis zur Bruchlast, bei dessen Erreichen ein Zeiger stehen bleibt und ein Direktablesen der Haftfestigkeit in N/mm² auf einer Skala des Geräts erlaubt.

Die Vergilbung wurde mit einem Lange-Colorpen-Spektralphotometer (400-700 nm; 20 n) analog DIN 6167, ISO 7724/1-3 und ASTM D 1925-70 bestimmt und wird als b-Wert angegeben.

Die Viskosität (mPa.s) wurde bestimmt nach DIN EN ISO 3217.

Als Maß der Reaktivität ist die Bandgeschwindigkeit angegeben, mit der bei Lackaufträgen von 50 g/m² der Lackfilm unter einer undotierten Quecksilberhochdrucklampe (Leistung 120 W/cm Lampenlänge; Lampenabstand zum Substrat 12 cm) durchgefahren werden kann, um eine gegenüber dem Fingernagel kratzfeste Beschichtung zu erreichen.

### Beispiel 1

100 Teile eines handelsüblichen unter Michael-Addition eines Amins an C-C-Doppelbindungen aminmodifizierten Polyetheracrylats (Laromer® LR 8889 der BASF AG) mit einer Aminzahl von 45 wurden mit 5 Teilen eines handelsüblichen Pentaerythritglycidylether mit einem Epoxidwert von 6,1 mol/kg (Basoset® 162 der BASF AG) und 4 Teilen eines handelsüblichen Photoinitiatorgemischs aus gleichen Mengen von Benzophenon und 1-Hydroxycyclohexylphenylketon (Irgacure® 500 der Fa. Ciba-Geigy S.A.) vermischt. Die Mischung hatte eine Aminzahl von 41,3 und einen Epoxidwert von 0,3 mol/kg. Mit der Mischung wurde ein Bonderblech (phosphatiertes Stahlblech) als Substrat in einer Schichtdicke von 67 µm durch Rakeln beschichtet. Die Lackschicht wurde mit UV-Licht zweimal mit 120 W/cm gehärtet und bei 100 °C getempert. Die Erichsentiefung betrug vor dem Tempern 3,1 und nach 72 Stdn. bei 100 °C 3,8. Die Haftung (GT-Werte) betrug vor dem Tempern 5,0/5(mT) und verbesserte sich auf 1/2,5 (mT) nach 24 Stdn. bei 100 °C und auf 0/0(mT) nach 72 Stdn. Tempern bei 100 °C.

### Beispiel 2 (Vergleichsversuch zu Beispiel 1)

Es wurde wie in Beispiel 1 verfahren, jedoch erfolgte keine Zumischung von Pentaerythritglycidylether. Die Schichtdicke betrug 63 µm. Nach Strahlungshärtung und vor dem Tempern zeigte die Schicht eine Erichsentiefung von 4,1. Nach 24 stündigem Tempern bei 100 °C war die Schicht im Gegensatz zu Beispiel 1 voller Risse.

### Beispiel 3

Es wurde wie in Beispiel 1 verfahren, jedoch auf dem Bonderblech die epoxidhaltige Mischung in einer Schichtdicke von 30 µm aufgetragen und nach der UV-Härtung wie vorstehend angegeben geprüft und getempert. Die Lackschicht hatte vor dem Tempern eine Erichsentiefung (ET) von 3,5; nach dem Tempern bei 100 °C betrug der ET-Wert: nach 72 Stunden 4,8; nach 168 Stunden 5,3 und nach 336 Stunden 6,2. Die Haftung (GT-Wert) betrug vor dem Tempern 5/5(mT), beim Tempern bei 100 °C nach 96 Stunden 0,5/0,5(mT); nach 168 Stunden 0/0 (mT) und nach 336 Stunden 0/0(mT). Der Lackfilm zeigte somit für lange Zeit mit zunehmender Temperzeit eine zunehmende Haftfestigkeit.

### Beispiel 4 (Vergleichsversuch zu Beispiel 3)

Es wurde wie in Beispiel 3 verfahren, jedoch enthielt die Lackmischung keinen Pentaerythritglycidylether. Die Schichtdicke betrug 30 µm. Die ET-Werte betrugen vor dem Tempern 3,3, beim Tempern bei 100 °C: nach 96 Stunden 4,4; nach 168 Stunden 4,4. Danach war der Film gerissen. Die Haftung (GT-Wert) betrug vor dem Tempern 5/5(mT), beim Tempern bei 100 °C nach 96 Stunden 0,5/3,5(mT) und nach 168 Stunden 0,5/5 (mT).

### Beispiel 5

Es wurde wie in Beispiel 1 verfahren, jedoch als Substrat ein weiß-lackiertes Bonderblech verwendet. Die Schichtdicke betrug 65 µm. Nach der UV-Härtung wurde die Lackschicht bei 100 °C getempert und die Vergilbung b bestimmt. Die Ergebnisse zeigt Tabelle 1.

### Beispiel 6 (Vergleichsversuch zu Beispiel 5)

Es wurde wie in Beispiel 5 verfahren, jedoch im Lack der Zusatz einer Epoxidverbindung weggelassen. Nach der UV-Härtung wurde die Lackschicht bei 100 °C getempert und die Vergilbung bestimmt. Die Ergebnisse zeigt Tabelle 1.

**Tabelle 1**

| Vergilbungswerte b beim Tempern der Lacke von Beispiel 5 und Beispiel 6 (Vergleich) | | | | | | | | |
|---|---|---|---|---|---|---|---|---|
| Temperzeit (Stunden) | Substrat | 0 | 24 | 48 | 72 | 144 | 240 | 384 |
| Vergilbung b Beispiel 5 (mit Epoxid) | 0,0 | 2 | 4,9 | 5,2 | 5,5 | 6,6 | 7,6 | 9,3 |
| Vergilbung b Beispiel 6 (ohne Epoxid) | 0,2 | 2 | 6,3 | 7,6 | 8,1 | 9,4 | 9,7 | 10,3 |

### Beispiel 7

Es wurde wie in Beispiel 5 verfahren, die Schichtdicke betrug jedoch 29 µm. Nach der UV-Härtung wurde die Lackschicht bei 100 °C getempert und die Vergilbung b bestimmt. Die Ergebnisse zeigt Tabelle 2.

### Beispiel 8 (Vergleichsversuch zu Beispiel 7)

Es wurde wie in Beispiel 7 verfahren, jedoch wurde der Zusatz einer Epoxidverbindung zum Lack weggelassen. Die Schichtdicke betrug 31 µm. Nach der UV-Härtung wurde die Lackschicht bei 100 °C getempert und die Vergilbung b bestimmt. Die Ergebnisse zeigt Tabelle 2.

**Tabelle 2**

| Vergilbungswerte b beim Tempern der Lacke von Beispiel 7 und Beispiel 8 (Vergleich) | | | | | | |
|---|---|---|---|---|---|---|
| Temperzeit (Stunden) | Substrat | 0 | 24 | 96 | 168 | 336 |
| Vergilbung b Beispiel 7 (mit Epoxid) | 0,1 | 1.9 | 4,2 | 5,3 | 5.6 | 6.9 |
| Vergilbung b Beispiel 8 (ohne Epoxid) | 0,0 | 1,9 | 5,1 | 6,5 | 6,6 | 6,9 |

### Beispiele 9 - 15

Es wurden 7 Ansätze hergestellt von einer Mischung von 50 Teilen eines handelsüblichen unter Michael-Addition eines Amins an C-C-Doppelbindungen aminmodifizierten Polyesteracrylats (Laromer® LR 8907 der BASF AG) mit einer Aminzahl von 24, 50 Teilen eines handelsüblichen in gleicher Art aminmodifizierten Polyetheracrylats (Laromer® LR 8889 der BASF AG) mit einer Aminzahl von 45 und 4 Teilen des in Beispiel 1 angegebenen Photoinitiator-Gemisches Irgacure® 500.

Ein Ansatz wurde ohne Zusatz einer Epoxidverbindung verarbeitet (Beispiel 9), drei Ansätzen wurde Epikote® 828 (unmodifiziertes Bisphenol A-Epichlorhydrin-Epoxidharz) mit einem Epoxidwert von 6,3 mol/kg in Mengen von 2,5 Teilen (Beispiel 10), 5 Teilen (Beispiel 11) und 10 Teilen (Beispiel 12) zugemischt und drei Ansätzen wurde Basoset® 162 (Pentaerythritglycidylether) mit einem Epoxidwert von 6,1 mol/kg in Mengen von 2,5 Teilen (Beispiel 13), 5 Teilen (Beispiel 14) und 10 Teilen (Beispiel 15) zugemischt.

Bestimmt wurden die Reaktivitäten der resultierenden Mischungen. Bestimmt wurden ferner die Viskositäten der Mischungen direkt nach ihrer Herstellung und nach 16 stündigem Tempern bei 80 °C. Bestimmt wurden ferner mit dem Twistometer die Haftfestigkeiten der Lackschichten der Ansätze (Auftragsmenge 25 g/m²) auf entfetteten Tiefziehblechen nach der UV-Härtung (120W/cm, Bandgeschwindigkeit 10 m/min) und anschließendem einstündigem Tempern bei 125 °C. Bestimmt wurden ferner die Haftungen (Gitterschnittwerte) der Lackschichten der Ansätze (Auftragsmenge 50 g/m²) auf einer mit einem Melaminharzüberzug versehenen Schichtstoffplatte (Rhenodurplatte) nach UV-Härtung und 3stündigem Tempern bei 80 °C sowie nach anschließendem Lagern bei Raumtemperatur (RT). Bestimmt wurden ferner die Vergilbungen als b-Werte.

Eine Übersicht der Versuche und Versuchsergebnisse zeigt Tabelle 3. Danach findet bei Beispiel 15 eine signifikante Reaktion statt und ohne Tempern unterscheiden sich die Ergebnisse der Beispiele 10 bis 15 nicht stark von denen des Beispiels 9.

**Tabelle 3**

| Ergebnisse der Beispiele 9 bis 15 | | | | | | | |
|---|---|---|---|---|---|---|---|
| Beispiel | 9 | 10 | 11 | 12 | 13 | 14 | 15 |
| LR 8907 (Teile) | 50 | 50 | 50 | 50 | 50 | 50 | 50 |
| LR 8889 (Teile) | 50 | 50 | 50 | 50 | 50 | 50 | 50 |
| Initiator (Teile) | 4 | 4 | 4 | 4 | 4 | 4 | 4 |
| Epikote 828 (Teile) | 0 | 2,5 | 5 | 10 | 0 | 0 | 0 |
| Basoset 162 (Teile) | 0 | 0 | 0 | 0 | 2,5 | 5 | 10 |
| Aminzahl d. Mischung | - | 32,4 | 31,6 | 30,2 | 32,4 | 31,6 | 30,2 |
| Epoxidwert d. Mischung (mol/kg) | - | 0,12 | 0,24 | 0,46 | 0,14 | 0,28 | 0,54 |
| Reaktivität m/min;50g/m² | 25 | 25 | 25 | 25 | 25 | 25 | 25 |
| Viskosität sofort | 1 | 1,1 | 1,2 | 1,3 | 1,1 | 1,1 | 1,2 |
| Viskosität 16 Std.80°C | 1,9 | 1,1 | 1 | 2 | 1,4 | 1,2 | 3,2 |
| 25 g/m² Haftfestigkeit Twistometer TZ-Blech 10 m/min UV Tempern: 1 Std.125°C | 19,3 | 19,8 | 20 | 24 | 19,5 | 21 | 28,5 |
| 50 g/m² Haftung GT Rhenodurpl. 10 m/min UV Tempern: 3 Std. 80 °C | GT 4 | GT 4 | GT 4 | GT 4 | GT 4 | GT 4 | GT 3 |
| 50 g/m² Haftung GT Rhenodurpl. 10 m/min UV Tempern: 3 Std. 80°C +24 Std.RT | GT 4 | GT 4 | GT 4 | GT 4 | GT 3,5 | GT 2 | GT 0,5 |
| Vergilbung b nach Tempern 3 Std. 80°C +24 Std.RT | 7,5 | 6,6 | 6,5 | 6 | 6,4 | 6,1 | 5,7 |

### Beispiele 16 - 20

Es wurden vergleichende Versuche zur Lagerstabilität von Mischungen eines nicht-aminmodifizierten Polyesteracrylats (Laromer® LR 8912) mit Photoinitiator Irgacure® 500, den Epoxidverbindungen Basoset® 162 (siehe Beispiel 1) und Epikote® 828 (siehe Beispiel 9), wobei einerseits Methyldiethanolamin (MDEA) als Amin (Beispiele 16,18,19), andererseits aminmodifizierte Acrylatharze als Amine (Beispiel 20) eingesetzt wurden. Die Viskosität wurde jeweils sofort nach der Herstellung der Mischungen gemessen sowie nach 24 stündigem Tempern bei 60 °C (Beispiele 16-19) bzw. 16 stündigem Tempern bei 80 °C (Beispiel 20). Die Ergebnisse zeigt Tab. 4, wonach eine Kombination von aminmodifizierten Acrylatharzen mit einem Epoxid eine gute Lagerstabilität zeigte (Beispiel 20), was bei den Kombinationen von (aminogruppenfreien) Acrylatharzen mit einer Epoxidverbindung und Methyldiethanolamin nicht der Fall war.

**Tabelle 4**

| Vergleichende Versuche zur Lagerstabilität | | | | | |
|---|---|---|---|---|---|
| Beispiel | 16 | 17 | 18 | 19 | 20 |
| Acrylatharz LR 8912 (Teile) (ohne Aminogr.) | 100 | 100 | 100 | 100 | 0 |
| Acrylatharz LR 8907 (Teile) (mit Aminogr.) | 0 | 0 | 0 | 0 | 50 |
| Acrylatharz LR 8889 (Teile) (mit Aminogr.) | 0 | 0 | 0 | 0 | 50 |
| Initiator (Teile) | 4 | 4 | 4 | 4 | 4 |
| Epikote 828(Teile) | 0 | 0 | 0 | 10 | 10 |
| Basoset 162(Teile) | 0 | 10 | 10 | 0 | 0 |
| Methyldiethanolamin (Teile) | 3 | 0 | 3 | 3 | 0 |
| Viskosität mPa.s sofort | 3,8 | 3,1 | 3,4 | 4,2 | 1,3 |
| Viskosität mPa.s n.24 Std. 60 °C (16 Std.80°C) | 3,6 | 3,2 | 15,2 | 22 | 2 |

## Patentansprüche

1. Verfahren zur Verbesserung der Haftung von strahlungshärtbaren Acrylatharzen, die eine Verbindung mit mindestens einer Amingruppe und mindestens einer strahlungshärtbaren ungesättigten Acrylatgruppe enthalten, auf Substraten, **dadurch gekennzeichnet, daß** man den Acrylatharzen mindestens eine härtbare Polyepoxidverbindung mit einem Epoxidwert von 1 bis 15 mol/kg zumischt, das erhaltene Gemisch auf das Substrat aufbringt und mit energiereicher Strahlung und durch Behandlung bei einer Temperatur über ca. 50 °C härtet.

2. Verfahren nach Anspruch 1, **dadurch gekennzeichnet, daß** die Polyepoxidverbindung mindestens 2 Glycidyletheroder Glycidylestergruppen enthält.

3. Verfahren nach Anspruch 1 oder 2, **dadurch gekennzeichnet, daß** das strahlungshärtbare Acrylatharz mindestens ein aminmodifiziertes Acrylatharz mit Amin- und ungesättigten Acrylatgruppen mit einer Aminzahl von 5 bis 450 mg KOH/g enthält oder aus einem solchen aminmodifizierten Acrylatharz als alleinigem Bindemittel besteht.

4. Verfahren nach einem der Ansprüche 1 bis 3, **dadurch gekennzeichnet, daß** die Acrylatharzmischung eine Aminzahl von 5 bis 250 mg KOH/g aufweist.

5. Verfahren nach einem der Ansprüche 1 bis 4, **dadurch gekennzeichnet, daß** der Epoxidwert der Mischung 0,1 bis 4 mol/kg beträgt.

6. Verfahren nach einem der Ansprüche 1 bis 5, **dadurch gekennzeichnet, daß** die Acrylatharzmischung zusätzlich Reaktivverdünner enthält.

7. Verfahren nach einem der Ansprüche 1 bis 6, **dadurch gekennzeichnet, daß** man die Acrylatharzmischung nach ihrem schichtförmigen Auftragen auf das Substrat durch Bestrahlung härtet und anschließend bei einer Temperatur über ca. 50 °C behandelt.

8. Verfahren nach einem der Ansprüche 1 bis 7, **dadurch gekennzeichnet, daß** man die Polyepoxidverbindungen in Gegenwart der Amingruppen der aminmodifizierten Acrylatharze durch Behandlung bei einer Temperatur von ca. 50 bis 120 °C zumindest teilweise härtet.

9. Verfahren nach einem der Ansprüche 1 bis 8, **dadurch gekennzeichnet, daß** man die Acrylatharzmischung nach ihrem schichtförmigen Auftragen auf das Substrat durch Bestrahlung härtet und danach bei einer Temperatur von ca. 50 bis 120 °C während ca. 5 bis 240 Minuten behandelt.

10. Verfahren nach einem der Ansprüche 1 bis 9, **dadurch gekennzeichnet, daß** die Acrylatharzmischung 1 bis 20 Gew.%, bezogen auf die Gesamtmenge der Acrylatharzmischung, mindestens eines Photoinitiators enthält, und man die Mischung nach dem schichtförmigen Auftragen auf das Substrat mit UV-Strahlung photopolymerisiert.

11. Verfahren nach einem der Ansprüche 1 bis 10, **dadurch gekennzeichnet, daß** mit den Acrylatharzmischungen Metall- oder Kunststoffsubstrate beschichtet werden.

## Claims

1. A process for improving the adhesion of radiation-curable acrylate resins, comprising a compound containing at least one amine group and at least one radiation-curable unsaturated acrylate group, to substrates, which comprises admixing the acrylate resins with at least one curable polyepoxide compound having an epoxide value of from 1 to 15 mol/kg, applying the resultant mixture to the substrate, and curing it with high-energy radiation and by treatment at a temperature of above about 50°C.

2. A process as claimed in claim 1, wherein the polyepoxide compound comprises at least 2 glycidyl ether or glycidyl ester groups.

3. A process as claimed in claim 1 or 2, wherein the radiation-curable acrylate resin comprises at least one amine-modified acrylate resin having amine groups and unsaturated acrylate groups, with an amine number of from 5 to 450 mg KOH/g, or consists of such an amine-modified acrylate resin as sole binder.

4. A process as claimed in any of claims 1 to 3, wherein the acrylate resin mixture has an amine number of from 5 to 250 mg KOH/g.

5. A process as claimed in any of claims 1 to 4, wherein the epoxide value of the mixture is from 0.1 to 4 mol/kg.

6. A process as claimed in any of claims 1 to 5, wherein the acrylate resin mixture further comprises reactive diluents.

7. A process as claimed in any of claims 1 to 6, wherein following its application in layers to the substrate the acrylate resin mixture is cured by irradiation and subsequently treated at a temperature of above about 50°C.

8. A process as claimed in any of claims 1 to 7, wherein the polyepoxide compounds are at least partially cured in the presence of the amine groups of the amine-modified acrylate resins by treatment at a temperature of from about 50 to 120°C.

9. A process as claimed in any of claims 1 to 8, wherein following its application in layers to the substrate the acrylate resin mixture is cured by irradiation and subsequently treated at a temperature of from about 50 to 120°C for from about 5 to 240 minutes.

10. A process as claimed in any of claims 1 to 9, wherein the acrylate resin mixture comprises from 1 to 20% by weight, based on the total amount of the acrylate resin mixture, of at least one photoinitiator, and the mixture, following its application in layers to the substrate, is photopolymerized with UV radiation.

11. A process as claimed in any of claims 1 to 10, wherein metal substrates or plastic substrates are coated with the acrylate resin mixtures.

## Revendications

1. Procédé pour améliorer l'adhésion de résines acrylates durcissables par rayonnement et contenant un composé comportant au moins un groupe amine et au moins un groupe acrylate insaturé durcissable par rayonnement sur des substrats, **caractérisé en ce que** l'on mélange les résines acrylates à au moins un composé polyépoxyde durcissable d'une valeur époxyde de 1 à 15 moles/kg, que l'on applique le mélange obtenu sur le substrat et que l'on opère le durcissement au moyen d'un rayonnement à haute énergie et par traitement à une température de plus d'environ 50°C.

2. Procédé selon la revendication 1, **caractérisé en ce que** le composé polyépoxyde contient au moins 2 groupes d'éther glycidylique ou d'ester glycidylique.

3. Procédé selon la revendication 1 ou 2, **caractérisé en ce que** la résine acrylate durcissable par rayonnement contient au moins une résine acrylate modifiée par une amine avec des groupes amine et acrylate insaturé d'un indice d'amine de 5 à 450 mg de KOH/g ou consiste en une telle résine acrylate modifiée par une amine en tant qu'unique liant.

4. Procédé selon l'une quelconque des revendications 1 à 3, **caractérisé en ce que** le mélange de résines acrylates présente un indice d'amine de 5 à 250 mg de KOH/g.

5. Procédé selon l'une quelconque des revendications 1 à 4, **caractérisé en ce que** la valeur époxyde du mélange est de 0,1 à 4 moles/kg.

6. Procédé selon l'une quelconque des revendications 1 à 5, **caractérisé en ce que** le mélange de résines acrylates contient en outre un diluant réactif.

7. Procédé selon l'une quelconque des revendications 1 à 6, **caractérisé en ce que**, après son application en couche sur le substrat, on durcit le mélange de résines acrylates par irradiation et on le traite ensuite à une température de plus d'environ 50°C.

8. Procédé selon l'une quelconque des revendications 1 à 7, **caractérisé en ce que** l'on durcit au moins partiellement les composés époxydes en présence des groupes amine de la résine acrylate modifiée par une amine à une température d'environ 50 à 120°C.

9. Procédé selon l'une quelconque des revendications 1 à 8, **caractérisé en ce que**, après son application en couche sur le substrat, on durcit le mélange de résines acrylates par irradiation et on le traite ensuite à une température d'environ 50 à 120°C pendant environ 5 à 240 minutes.

10. Procédé selon l'une quelconque des revendications 1 à 9, **caractérisé en ce que** le mélange de résines acrylates contient de 1 à 20% en poids, par rapport à la quantité totale de mélange de résines acrylates, d'au moins un photoinitiateur, et que le mélange est photopolymérisé après son application en couche sur le substrat, au moyen de rayons UV.

11. Procédé selon l'une quelconque des revendications 1 à 10, **caractérisé en ce que** l'on recouvre avec le mélange de résines acryliques des substrats de métal ou de plastique.
